# EUROPEAN PATENT APPLICATION

(11) **EP 3 376 540 A1**
(43) Date of publication of application: **19.09.2018**
(21) Application number: 17162773.0
(22) Date of filing: 24.03.2017
(51) Int. Cl.: H01L 27/11524, H01L 21/768, H01L 27/11556, H01L 27/1157, H01L 27/11582

(54) **3D MEMORY DEVICE WITH LAYERED CONDUCTORS**

(30) Priority: 17.03.2017 US 201715462201
(71) Applicant: MACRONIX INTERNATIONAL CO., LTD., Hsinchu (TW)
(72) Inventor: HUANG, Yukai, Taipei City 112 (TW); LUOH, Tuung, Taipei City105 (TW); YANG, Ta-Hung, Miaoli County 351 (TW); CHEN, Kuang-Chao, Taipei City 105 (TW)
(74) Representative: Gunzelmann, Rainer

(57) **Abstract**

An integrated circuit includes a multilayer stack, and a plurality of layered conductors extending in the multilayer stack and into a conductor layer beneath the multilayer stack. The layered conductor has a bottom conductor layer in ohmic electrical contact with the conductive layer in a substrate, an intermediate conductive interface layer over the bottom conductor layer and lining a portion of sidewall of the corresponding trench, and a top conductor layer on the top conductive interface layer.

## Description

### BACKGROUND

### Field

The present technology relates to high density memory devices, particularly to three-dimensional memory devices having a plurality of layered conductors filling the corresponding trenches.

### Description of Related Art

Stacking multiple levels of memory cells to achieve greater storage capacity has been proposed. Researchers have been developed various structures, such as Bit Cost Scalable (BiCS) memory, Terabit Cell Array Transistor (TCAT) and Vertical NAND (V-NAND). For these types of structures, and other complex structures that comprise stacks of active layers separated by insulating (or inactive) layers, it is often useful to form conductors connecting layers deep in the stacks with upper layers or with patterned metal layers over the stacks used for connection to peripheral circuits. When these conductors require low resistance or high current capacity, they can be formed by filling elongated trenches that are cut through the stacks, rather than in pillar shaped interlayer conductors formed in cylindrical or roughly cylindrical vias.

However, the formation of these conductor-filled trenches can be difficult. Once a high aspect ratio trench is formed in a stack of layers, it must be filled with a conductor. Filling deep trenches can stress the stacked structure. As the trench depth reaches and exceeds 1 micron, with an aspect ratio of 10 or more, the stress can cause deformation of the trench and of devices near the trench. This can be particularly problematic when there a multiple parallel conductors of this type being formed.

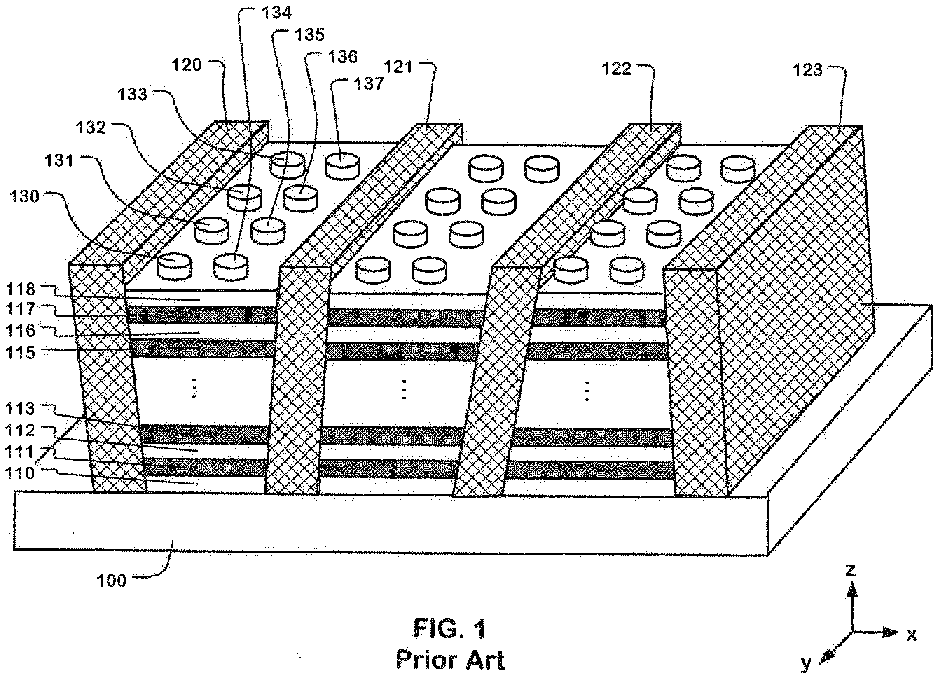

With the greater density storage, the structure would require more levels of memory cells, and with formation of deeper high aspect ratio trenches being required in the manufacturing process. Deformation of the trenches and of devices between the trenches can present challenges of connecting the conductive lines in the stack to the backend of line (BEOL) routings. The illustration of FIG. 1 represents a three-dimensional (3D) NAND non-volatile memory device, which has a stack of alternating conductive layers (*e.g.* active layers 111, 113, 115, 117) and insulating layers (*e.g.* inactive layers 110, 112, 116, 118) on a substrate 100, with a plurality of memory pillars (*e.g.* 130-137) in the stack. As seen in FIG. 1, the illustrated conductive lines 120, 121, 122, and 123 are deformed due to the process stresses, such as bending/warping of the wafer, the tensile/compressive stress caused by film deposition and thermal expansion due to changes in temperature, and so on. The illustration shows that such deformation can cause changes in the locations of the pillars and conductive lines. These changes in position can cause alignment problems with upper layer structures, and lead to misconnection to and/or misalignment of back-end-of-line (BEOL) routings.

It is desirable to form a plurality of conductor lines in a plurality of high-aspect-ratio trenches with reduced deformation. This can improve alignment tolerances for the BEOL routings and other structures.

### SUMMARY

A process for making elongated, conductor-filled trenches and the resulting structures are described, which can reduce stress induced deformation of the device being formed. Thus, in one aspect, an integrated circuit described herein comprises a multilayer stack of active and inactive layers over a substrate; a plurality of elongated trenches in the multilayer stack, the elongated trenches in the plurality extending from an upper layer of the multilayer stack to the substrate beneath the multilayer stack, and having sidewalls; and a plurality of layered conductors filling the corresponding elongated trenches in the plurality of elongated trenches, a layered conductor in the plurality of layered conductors including a bottom conductor layer in electrical contact with the substrate, a top conductor layer over the bottom conductor layer and, and an intermediate conductive interface layer between the top conductor layer and a portion of the sidewalls of the corresponding trench.

In another aspect, a method of making an integrated circuit described herein comprises forming a multilayer stack of active and inactive layers over a substrate; forming a plurality of elongated trenches in the multilayer stack, the elongated trenches in the plurality of elongated trenches extending from an upper layer of the multilayer stack to the substrate beneath the multilayer stack; lining sides of the elongated trenches in the plurality of elongated trenches with an insulating layer; and filling the elongated trenches in the plurality of elongated trenches with layered conductors, including forming the layered conductors in the corresponding elongated trenches in the plurality of elongated trenches by forming a bottom conductor layer in the corresponding trench over the insulating layer and in electrical contact with the substrate, forming an intermediate conductive interface layer over the bottom conductor layer and lining a portion of the insulating layer, and forming a top conductor layer on the intermediate conductive interface layer.

In yet another aspect, an integrated circuit described herein comprises a plurality of trenches extending in a stack of active and inactive layers and into a conductive plate beneath the stack; a plurality of layered conductors filling the corresponding trenches in the plurality of trenches, each layered conductor including a bottom conductor layer in electrical contact with the conductive plate, an intermediate conductive interface layer over the bottom conductor layer and lining a portion of sidewall of the corresponding trench, and a top conductor layer on the intermediate conductive interface layer; and a plurality of pillars in the stack between a pair of the layered conductors in the plurality of layered conductors, memory cells disposed at interface regions between the active layers and the pillars.

Other aspects and advantages of the present technology can be seen on review of the drawings, the detailed description and the claims, which follow.

### BRIEF DESCRIPTION OF THE DRAWINGS

FIG. 1 is a perspective view illustrating deformation in a prior 3D memory device.
FIGs. 2-9 are perspective views illustrating structures during manufacturing stages for a 3D NAND memory in one embodiment as described herein.
FIG. 10 is a perspective view illustrating a 3D NAND memory in another embodiment.
FIG. 11 is a perspective view illustrating a 3D NAND memory in yet another embodiment.
FIG. 12 is a perspective view illustrating a 3D NAND memory in an alternative embodiment.
FIGs. 13- 15 are perspective views illustrating a 3D NAND memory in structures during manufacturing stages for a 3D NAND memory in one embodiment as described herein
FIG. 16 is a block diagram of an integrated circuit memory including a 3D memory array having layered conductors as described herein.

### DETAILED DESCRIPTION

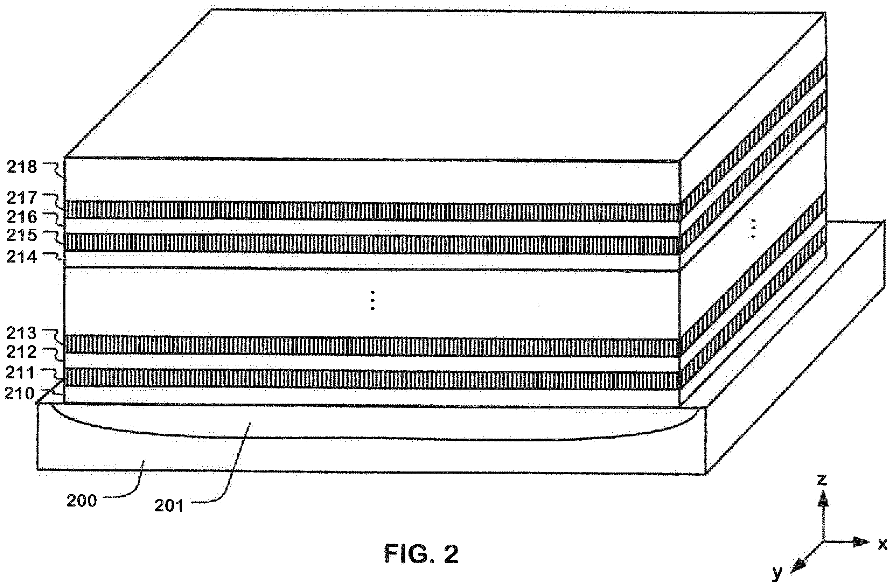

A detailed description of embodiments of the present invention is provided with reference to the FIGs. 2-9.

FIGs. 2 through 9 illustrate an example process flow for an integrated circuit comprising a vertical channel three-dimensional structure.

FIG. 2 is a perspective view illustrating a stage of the process after formation of a stack of active and inactive layers over a substrate 200. The term "substrate" as used herein refers to any structure below the conductor-filled trenches describe herein, and can include multiple layers including more active and inactive layers, complex structures, such as underlying circuitry, bulk semiconductor of the wafer die, and so on. The substrate 200 can be for example a bounded conductive plate formed by a doping process, in which n-type or p-type doping materials are added to a semiconductor layer or bulk semiconductor to form a conductive layer 201. Then, a stack comprising active layers (*e.g.* 211, 213, 215, 217), inactive layers (*e.g.* 210, 212, 214, 216), and a top conductor layer 218 is formed deposited over the substrate 200 by any suitable deposition method, such as PVD, CVD, LPCVD or ALD. The number of layers in the stack depends on the design and density of the memory device. The active layers (*e.g.* 211, 213, 215, 217) in the stack comprise circuit structures of conductive material, such as doped/undoped polysilicon or metals. The inactive layers (*e.g.* 210, 212, 214, 216) in the stack may comprise silicon oxide, other insulating materials, and combinations of insulating materials. In this example, all of the inactive layers consist of the same material. In other examples, different materials can be used in different layers as suits a particular design goal. The top conductor layer 218 can comprise silicon oxide, silicon nitride, high-density plasma oxide (HDPOX), and the combinations thereof.

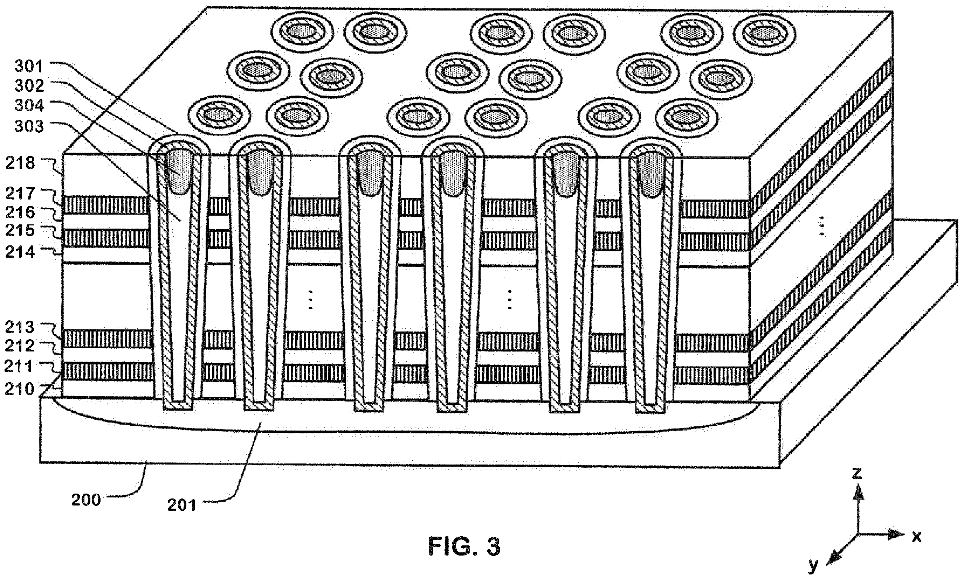

FIG. 3 is a perspective view illustrating a stage of the process after formation of a plurality of pillars through the stack into the substrate 200. A hole etch is implemented to form a plurality of cylindrical openings through the stack, followed by deposition of a memory layer 301 on the stack and within the openings in the plurality. The memory layer 301 can be a composite, multilayer film comprising a first layer, a second layer, and a third layer. The memory layer 301 has a conformal surface on the sidewalls and bottoms of the openings.

The first layer formed on the sidewalls of the openings comprises silicon oxide having a thickness of about 50Å to 130Å, and acts as a blocking layer. Other blocking dielectrics can include high-κ materials like aluminum oxide of 150Å.

The second layer formed on the first layer comprises silicon nitride having a thickness of about 40Å to 90Å, and acts as a charge trapping layer. Other charge trapping materials and structures may be employed, including, for example, silicon oxynitride (SiₓO_{y}N_{z}), silicon-rich nitride, silicon-rich oxide, trapping layers including embedded nano-particles and so on.

The third layer formed on the second layer comprises silicon oxide having a thickness of about 20Å to 60Å, and acts as a tunneling layer. In another example, other tunneling materials and structures may be employed, for example, composite tunneling structure.

A composite tunneling structure can comprise a layer of silicon oxide less than 2 nm thick, a layer of silicon nitride less than 3 nm thick, and a layer of silicon oxide less than 4 nm thick. In one embodiment, the composite tunneling structure consists of an ultrathin silicon oxide layer O₁ (*e.g*. ≤15Å), an ultrathin silicon nitride layer N₁ (*e.g.* ≤30Å) and an ultrathin silicon oxide layer O₂ (*e.g.* ≤35Å), which results in an increase in the valence band energy level of about 2.6 eV at an offset 15Å or less from the interface with the semiconductor body. The O₂ layer separates the N₁ layer from the charge trapping layer, at a second offset (*e.g.* about 30Å to 45Å from the interface), by a region of lower valence band energy level (higher hole tunneling barrier) and higher conduction band energy level. The electric field sufficient to induce hole tunneling raises the valence band energy level after the second location to a level that effectively eliminates the hole tunneling barrier, because the second location is at a greater distance from the interface. Therefore, the O₂ layer does not significantly interfere with the electric field assisted hole tunneling, while improving the ability of the engineered tunneling dielectric to block leakage during low fields.

The deposition techniques applied to form the composite, multilayer film can be carried out by low-pressure chemical vapor deposition (LPCVD), atomic layer deposition (ALD), other suitable methods, or combinations.

Next, an etch process is carried out to remove the memory layer 301 on the top of the stack and the bottoms of the openings. A thin film 302 is then deposited over the stack and has a portion in contact with the conductive layer 201 at the bottoms of the openings. The thin film 302 can comprise a semiconductor adapted by choice of material, *e.g.* silicon, and doping concentrations, *e.g.* undoped or lightly doped, to act as vertical channel structures.

After formation of the semiconductor thin film 302, a fill-in process is implemented using a spin-on dielectric (SOD), for example silicon oxide or other insulating materials, to fill the space between the thin film 302 within the openings, followed by a CMP process to remove the SOD on the top conductor layer 218 and an etch process to remove the SOD in the upper portions of the openings. So the insulating structures 303 are formed. In one example, the insulating structure 303 can be completely filled with the SOD, and be free of voids and seams. In another example, a seam or a void may exist in the insulating structure 303.

Next, a conductive material, for example polysilicon, is deposited to fill the upper portions of the openings, followed by CMP and/or etch back processes to form the plugs 304, thereby providing connections from the channels in the vertical strings of memory cells to the corresponding overlying patterned conductors (not shown). A salicide process is optionally applied to lower the resistance for better conductivity. In another example, the plugs 304 may comprise doped polysilicon.

In yet another example, the insulating structure 303 can be a seam or a gap, which is formed during the deposition of the thin film 302. The overhangs formed on the top of the inside surface of the thin film 302 may connect together so as to form the seam or gap enclosed by the thin film 302. The plug 304 is therefore formed by the overhangs being connected.

In yet another example, the thin film 302 completely fills the openings in the stack, and therefore, the insulating structure 303 and the plug 304 do not exist.

The pillars in the plurality in the stack include the memory layer 301 and the thin film 302. The memory cells are disposed at the interface regions between the active layers and the pillars. In this embodiment, the active layers acting as the word lines surround the pillar, which constitutes the all-around gates. The memory cells have gate-all-around configuration.

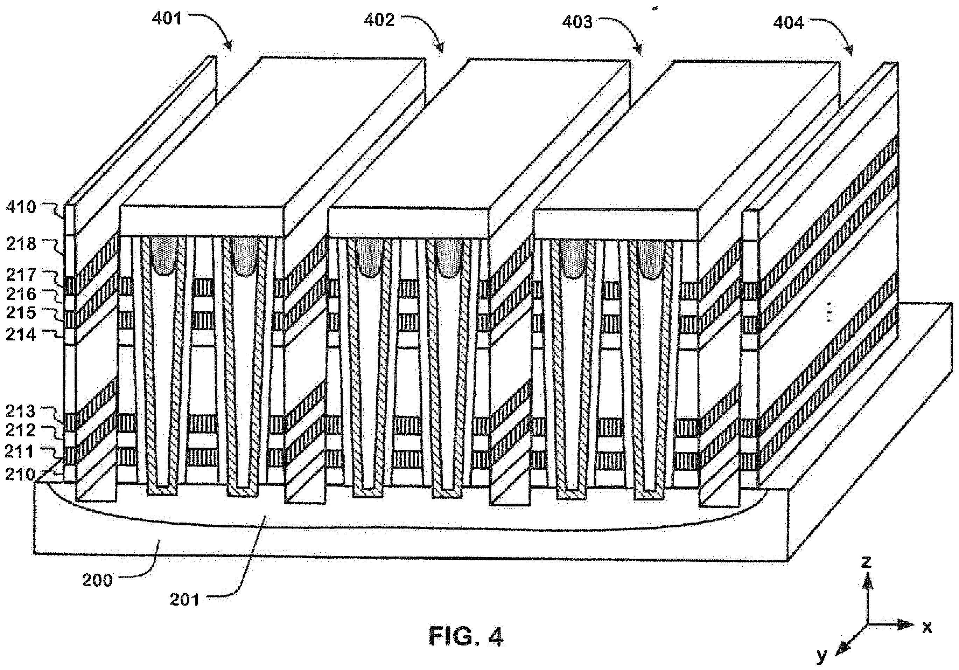

FIG. 4 is a perspective view illustrating a stage of the process after forming a plurality of elongated trenches in the multilayer stack, the elongated trenches in the plurality extending from an upper layer of the multilayer stack to the substrate beneath the multilayer stack using a single etch pattern. A cap layer 410, comprising for example silicon oxide, silicon nitride or other insulating materials, is formed over the stack, followed by creating a mask using photo lithography techniques for the patterning process to form a plurality of elongated trenches (*e.g.* 401, 402, 403, 404) in the stack and into the conductive layer 201 of the substrate 200. The elongated trenches in the plurality can be greater than 1µm deep, up to 8 µm for example, and greater than 0.1 µm wide, up to 0.8 µm for example. As such, the elongated trenches in the plurality have an aspect ratio of 10 or more.

The elongated trenches in the plurality are formed using one single patterning step, in which includes defining an etch mask for trenches, and etching using the mask, without further etch masks, so as to have continuous sidewalls extending from an upper layer of the multilayer stack to the substrate 200 beneath the multilayer stack. The term "continuous sidewalls" as used herein refers to sidewalls of a structure that results from use of a single etch pattern (which may be defined using a single etch mask, a multilayer etch mask including photoresist and a hard mask, or otherwise) in the etching of the trenches from the top conductor layer to the bottom conductor layer. Trenches with "continuous sidewalls" may have undulations as a result of etching the multiple materials of the multilayer stack including changing etch chemistries for different layers in the stack, but have no discontinuity as a result of multiple patterning steps using multiple etch patterns such as can be used in dual damascene processes.

The continuous sidewalls of the elongated trenches may be bowed or tapered or have other shaped profiles.

In other embodiments the 3D memory structure can be made using a so-called gate replacement process. In a gate replacement process, a stack of alternating materials including an insulator like silicon oxide and a sacrificial material like silicon nitride is formed. The stack is patterned to define an intermediate structure for the 3D structure, such as that shown in Figure 4. The sacrificial material is removed and conductive gate material is deposited in the voids left. In the gate replacement process, the active layers comprise these patterned gate conductors.

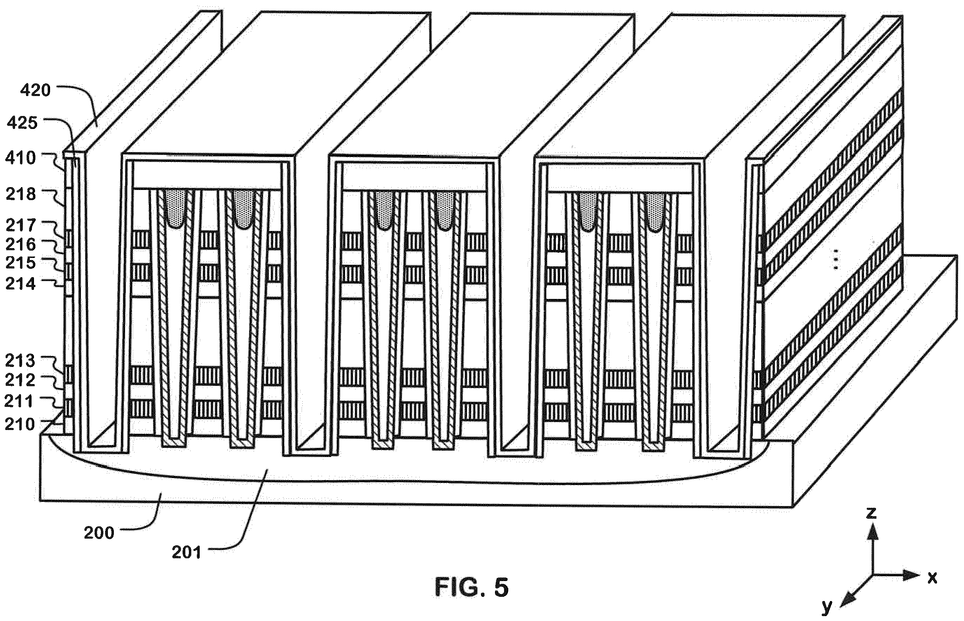

FIG. 5 is a perspective view illustrating a stage of the process after conformal deposition of an insulating layer 425 on the sidewalls of the trenches, removing the insulating layer 425 in the bottom of the trenches to expose a conductive layer 201 of the substrate 200, and then forming a first conductive interface layer 420 over the insulating layer 425 and over the cap layer 410 on the stack. Prior to depositing the first conductive interface layer 420, the insulating layer 425 is formed covering the sidewalls of the trenches and the top of cap layer 410. An etch step is then performed to remove the insulating layer in the bottom of the trenches. Therefore, the first conductive interface layer 420 can be in contact with the conductive layer 201 on the substrate 200.

The insulating layer 425 provides a continuous surface on the sidewalls of the trenches, which is considered the continuous sidewalls as described herein.

The insulating layer 425 comprises for example silicon oxide having a thickness of about 500Å and may be formed at a low temperature, for example 25°C. The insulating layer 425 may comprise other insulating materials and formed using other deposition methods.

The first conductive interface layer 420, such as a combination of titanium and titanium nitride, may be deposited using CVD, PVD, and ALD to form a layer of about 30Å to 1000 Å thick. Other materials suitable for the first conductive interface layer 420 comprise silicon nitride (SiN), Titanium (Ti), titanium nitride (TiN), tungsten nitride (WN), tantalum (Ta), tantalum nitride (TaN), other metal alloys, or combinations thereof. An annealing process is then optionally applied to the deposited first conductive interface layer 420.

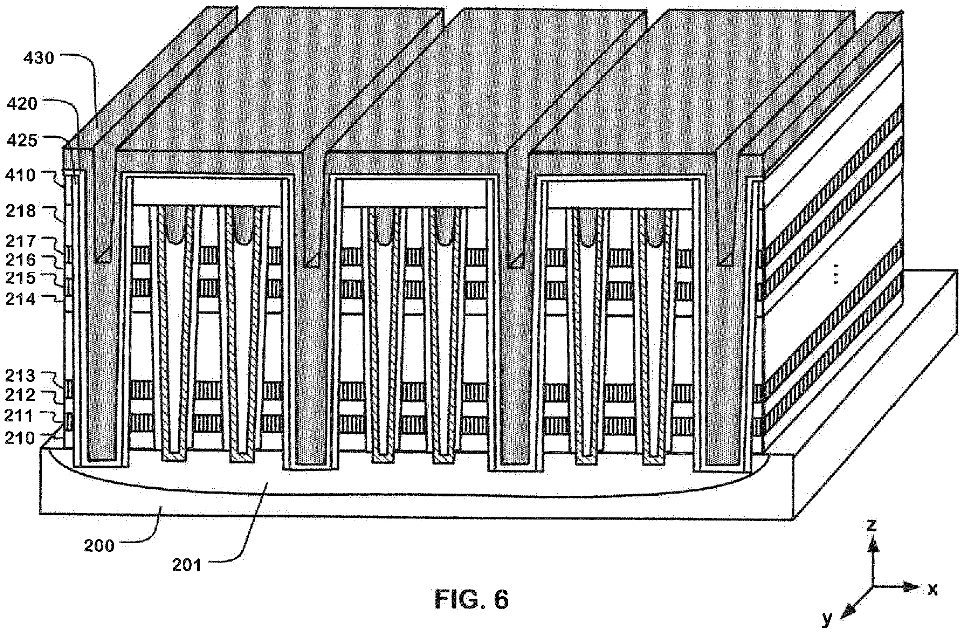

FIG. 6 is a perspective view illustrating a stage of the process after deposition of a first conducting layer 430 such as tungsten. The first conducting layer 430 may be formed using CVD, PVD, ALD, electroplating (EP) or other deposition techniques to partially fill in the space between the inner sidewalls of the first conductive interface layer 420 with a conductive material. In this embodiment, the first conducting layer 430 fills the lower portions of the trenches in the plurality. Other suitable materials for the first conducting layer 430 may comprise polysilicon, amorphous silicon, Titanium (Ti), titanium nitride (TiN), tungsten nitride (WN), tantalum (Ta), tantalum nitride (TaN), aluminum (Al), copper (Cu), cobalt (Co), other metals and metal alloys, or combinations thereof. An annealing process is then optionally applied to the deposited first conductive interface layer 420.

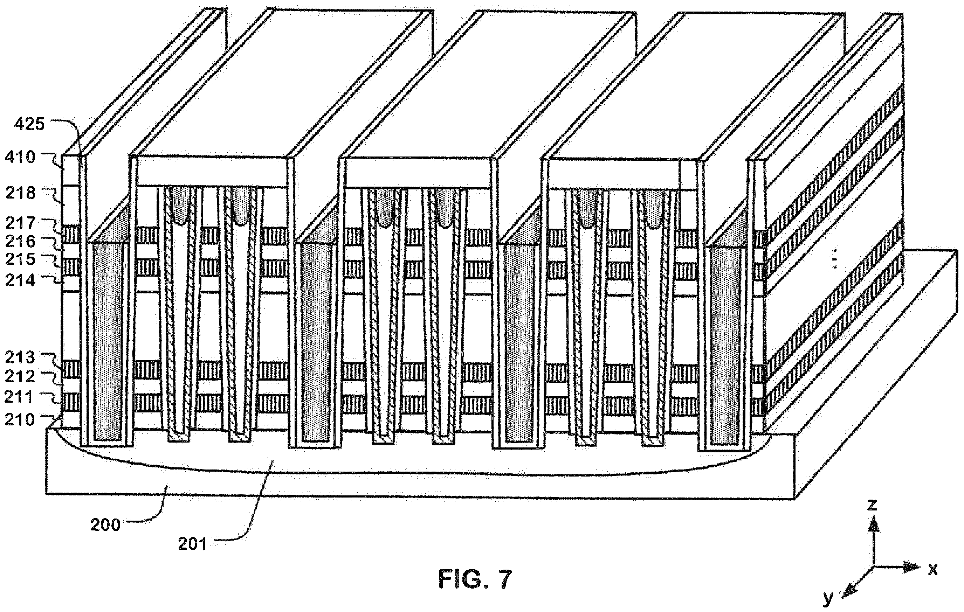

FIG. 7 is a perspective view illustrating a stage of the process after formation of the lower portion of a layered conductor in the respective one of trenches in the plurality. In one example, a CMP process is first applied to remove the first conductive interface layer 420 and the first conducting layer 430 on the top of the cap layer 410, followed by an etch process to remove the first conductive interface layer 420 and the first conducting layer 430 on the upper sidewalls of the trenches to expose a portion of insulating layer 425. The conductive materials for the first conducting layer 430 and the first conductive interface layer 420 are etched back to a top elevation in the stack forming a top surface. In this example, the top surface of the first conducting layer 430 can be at an elevation about two-thirds of the stack thickness, or can be at an elevation around the top active layer (*e.g.* 217) of the stack. The etch process can comprise wet etching, dry etching, Ar bombard, or the combinations thereof. In another example, only etch process(es) is performed to form the structure as illustrated in FIG. 7. The insulating layer 425 on the sidewalls of the trenches provides an etch selectivity when the first conductive interface layer 420 is etched.

As the trenches in the plurality are partially filled, the stack would have more space for thermal expansion during process while inducing less transverse stress on the stack. In addition, the partially filled high-aspect-ratio-trenches would decrease the tensile stress so as to improve the deformation issue.

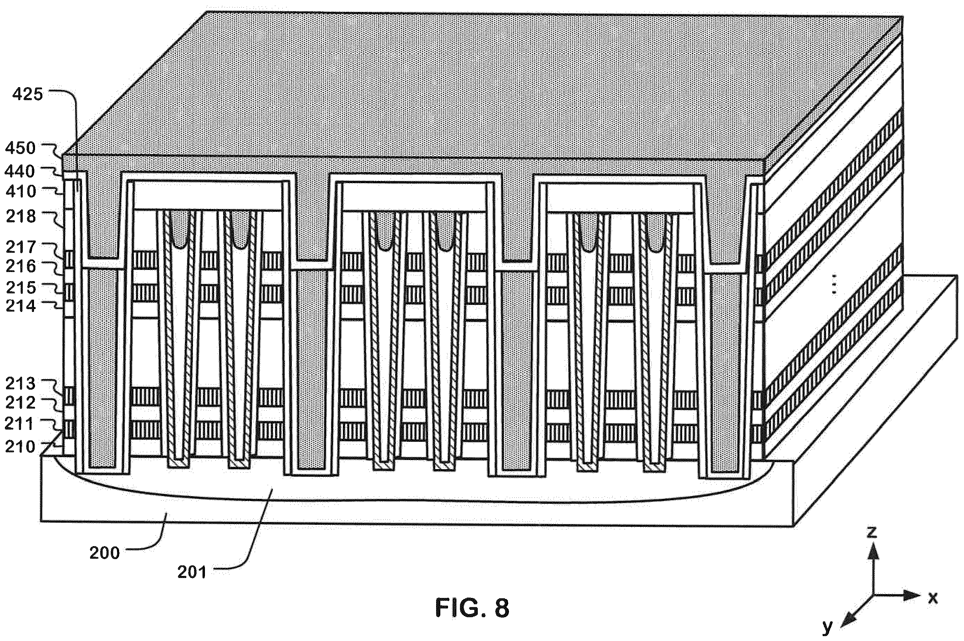

FIG. 8 is a perspective view illustrating a stage of the process after formation of a second conducting layer 450 on a second conductive interface layer 440 on the exposed portion of the insulating layer 425. The second conductive interface layer 440 formed using CVD, PVD, ALD, or other deposition techniques has a thickness about 10Å to 1000Å, lining a portion of the sidewalls of the trenches, thereby using the insulating layer 425 for alignment of the multiple layers of the conductors. The material suitable for the second conductive interface layer 440 may comprise silicon nitride (SiN), Titanium (Ti), titanium nitride (TiN), tungsten nitride (WN), tantalum (Ta), tantalum nitride (TaN), other metal alloys, or combinations thereof.

The second conducting layer 450, which can be different than the first conducting layer, is deposited to fill the upper portion of the trenches using CVD, PVD, ALD, EP or other deposition techniques. The material suitable for the second conducting layer 450 may comprise polysilicon, amorphous silicon, Titanium (Ti), titanium nitride (TiN), tungsten (W), tungsten nitride (WN), tantalum (Ta), tantalum nitride (TaN), aluminum (Al), copper (Cu), cobalt (Co), other metals and metal alloys, or combinations thereof. In some embodiments, the trench filling step can be done before the pillar formation.

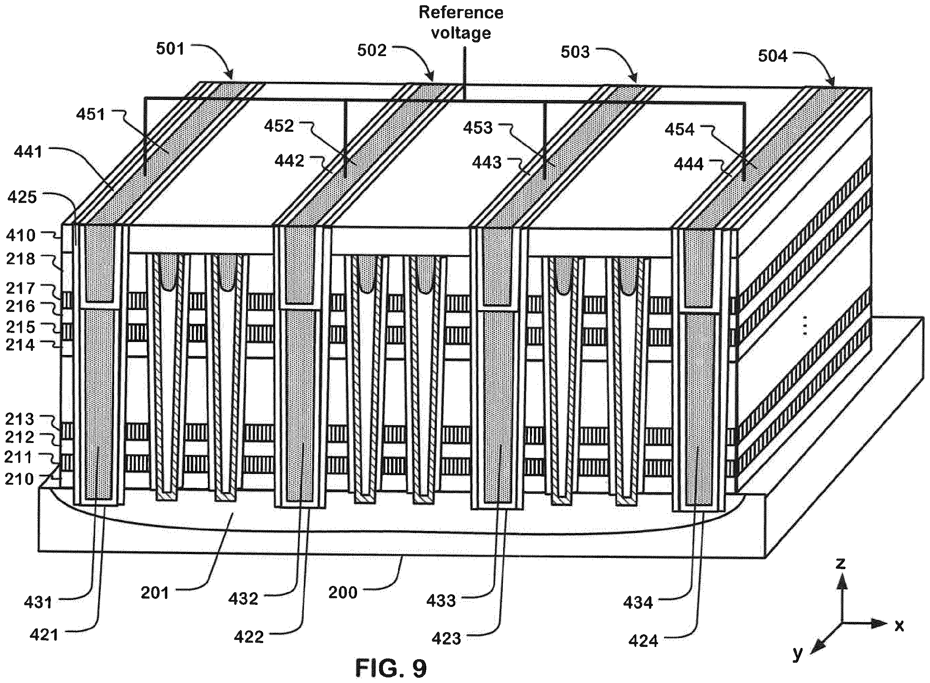

FIG. 9 is a perspective view illustrating a stage of the process after formation of the upper portion of a layered conductor in the respective one of trenches in the plurality. A CMP and/or etch process is implemented to remove the second conductive interface layer (440 of FIG. 8) and the second conducting layer (450 of FIG. 8) on the top of the cap layer 410. Therefore a plurality of layered conductors 501, 502, 503, 504 is formed in the corresponding trenches in the plurality. Each of the layered conductors 501, 502, 503, 504 in the plurality includes a bottom conductor layer 431, 432, 433, 434 in ohmic electrical contact with the substrate 200, an intermediate conductive interface layer 441, 442, 443, 444 over the bottom conductor layer 431, 432, 433, 434 and lining a portion of the sidewall of the corresponding trench, and a top conductor layer 451, 452, 453, 454 on the intermediate conductive interface layer 441, 442, 443, 444. The ohmic contact provides for current flow communication with suitable resistance between the layered conductors filling the elongated trenches and the underlying conductive layer 201 to enable use of the conductive layer 201 as a common source line. Each layered conductor includes a bottom conductive interface layer 421, 422, 423, 424 between the bottom conductor layer 431, 432, 433, 434 and a lower portion of the sidewall adjacent the bottom conductor layer 431, 432, 433, 434 in this embodiment.

The bottom conductive interface layers 421, 422, 423, 424 may have the same material as the intermediate conductive interface layers 441, 442, 443, 444 in one example. In another example, the first and second conductive interface layers may have different materials.

Likewise, the bottom conductor layers 431, 432, 433, 434 may have the same material as the top conductor layers 451, 452, 453, 454 in one example. In another example, the top and bottom conductor layers may have different materials.

As schematically shown, a plurality of patterned conductors overlying the plurality of layered conductors 501, 502, 503, 504 and the multilayer stack is connected the plurality of layered conductors 501, 502, 503, 504 to a reference voltage, configured as a common source line. In addition, a second plurality of patterned conductors (not shown) overlying the multilayer stack each connects the respective one of the pillars in the plurality to a voltage supply, providing bit line voltages to the corresponding thin films (302 of FIG. 3) of the pillar, configured as bit lines. Control circuitry is configured to apply different bias voltages to the active layers and pillars in the multilayer stack, and can be configured to execute a program operation by which one, or more than one, bit of data can be stored in a selected memory cell.

The bottom conductor layers 431, 432, 433, 434 can be bulk conductors, used primarily as a conductor as opposed to as a thin film adhesion layer or thin film barrier layer, of the layered conductors 501, 502, 503 504. In effective embodiments, bottom conductor layers 431, 432, 433, 434 have a thickness greater than a combined height of at least two of the layers (e.g. layers 210, 211) in the stack. In effective embodiments, bottom conductor layers 431, 432, 433, 434 have a thickness of at least one-third of the stack height. In effective embodiments, bottom conductor layers 431, 432, 433, 434 have a thickness of at least two-thirds of the stack height, and other thicknesses sufficient to act as the primary bulk conductive material of the layered conductor in the trench. The bottom conductor layers 431, 432, 433, 434 can be thicker in a dimension normal to the substrate 200 than the top conductor layers 451, 452, 453, 454. The primary purpose of the bottom conductor layers 431, 432, 433, 434 is a bulk conductor.

The bottom interface layers 421, 422, 423, 424 below the bottom conductor layers 431, 432, 433, 434 are thin films which can function primarily as adhesive to assist or ensure the adhesion of the bottom conductor layers to the insulating layer 425 or ion barriers to protect the underlying substrate 200 from attack by ions like fluorine and chlorine. The bottom conductive interface layers 421, 422, 423, 424 can also function to avoid forming voids or hillocks on the surface of the substrate during formation of the bottom conductor layers. In addition, the bottom conductive interface layers 1421, 1422, 1423, 1424 can help growth of the bottom conductor layers 1431, 1432, 1433, 1434.

The intermediate conductive interface layers 441, 442, 443, 444 are thin films which can function as primarily as adhesives to ensure the adhesion of the top conductor layers to the insulating layer 425 and can help growth of the top conductor layers 451, 452, 453, 454.

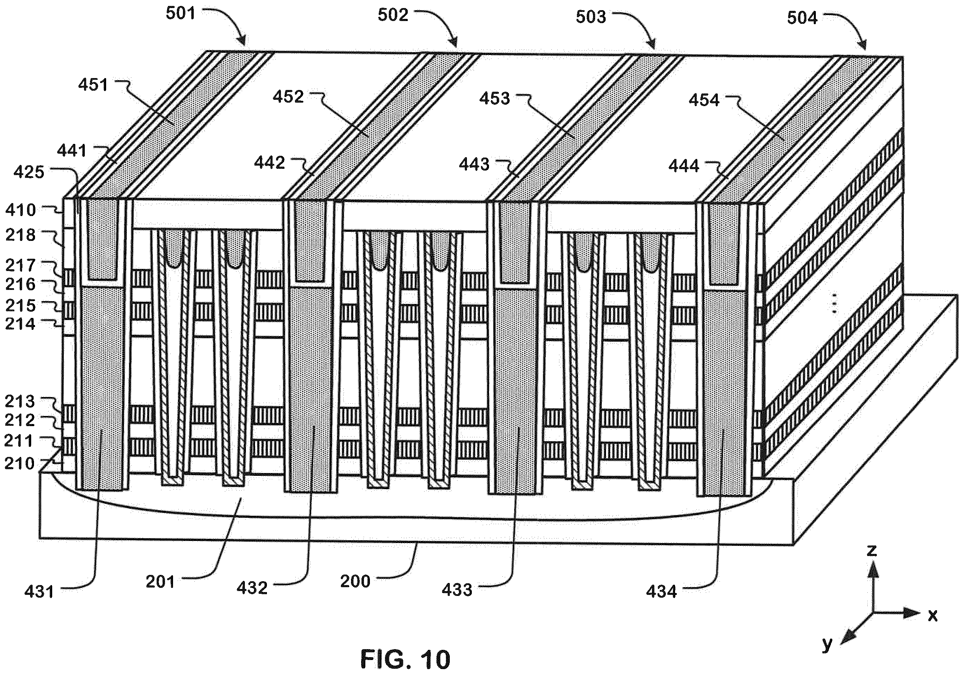

FIG. 10 is a perspective view of the three-dimensional memory structure in another embodiment. The same reference numerals used in FIG. 9 are generally applied to FIG. 10 to refer to the same or like elements of an embodiment. Description about the same or like elements is not repeated. Compared with the structure of FIG. 9, the bottom conductor layer 431, 432, 433, 434 directly contacts the conductive layer 201. In this embodiment, the bottom conductor layer can comprise for example polysilicon or other materials, which can provide good adhesion between the insulating and conducting materials. So the bottom barrier layers 421, 422, 423, 424 of FIG. 9 can be omitted. In this example, the bottom conductor layers 431. 432. 433. 434 can be thicker in a dimension normal to the substrate 200 than the top conductor layers 451. 452. 453, 454.

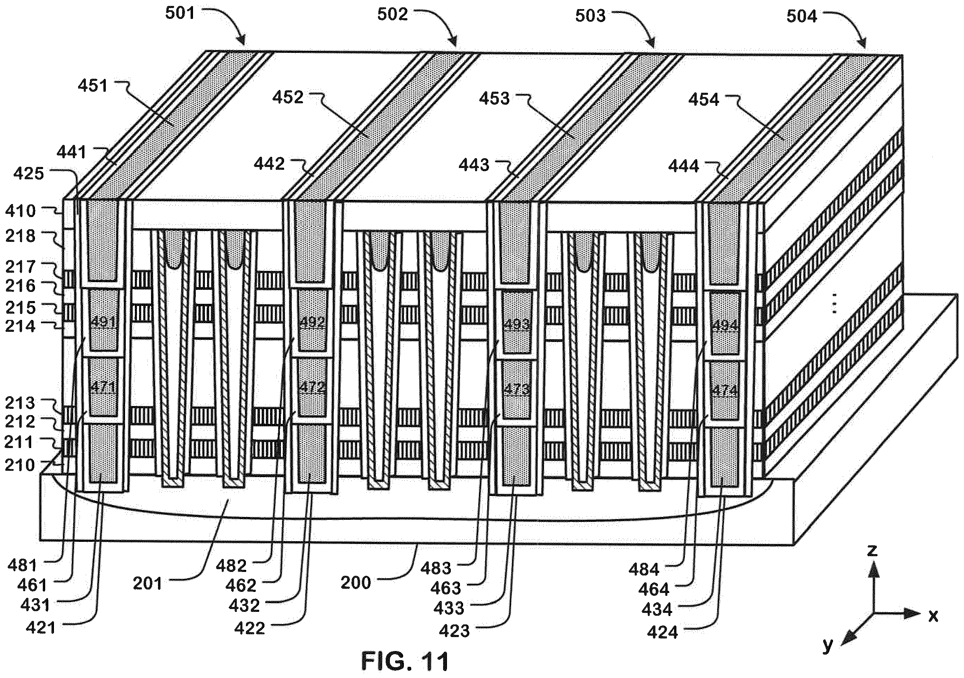

FIG. 11 is a perspective view of the three-dimensional memory structure in yet another embodiment. The same reference numerals used in FIG. 9 are generally applied to FIG. 11 to refer to the same or like elements of an embodiment. Description about the same or like elements is not repeated. Compared with the structure of FIG. 9, each layered conductor in the corresponding trench includes an intermediate conductor layer 471-474, 491-494 on an intermediate conductive interface layer 461-464, 481-484 between the top conductor layer 451, 452, 453, 454 and the bottom conductor layer 431, 432, 433, 434. In this embodiment, the layered conductor comprises two intermediate conductor layers and two intermediate conductive interface layers. The number of the intermediate conductor layers and intermediate conductive interface layers between the top and bottom conductor layers can be changed.

The intermediate conductive interface layers (*e.g.* 461-464, 481-484) function as primarily as adhesives to ensure the adhesion of the top conductor layers to the insulating layer 425 and can help growth of the top conductor layers 451, 452, 453, 454. As the intermediate conductive interface layers (*e.g.* 441, 442, 443, 444) are disposed on top of the intermediate conductive interface layers (*e.g.* 461-464, 481-484) and adhere to the sidewalls of the trenches (the insulating layer 425), the intermediate conductive interface layers (*e.g.* 461-464, 481-484) between the top and bottom conductor layers can be optionally omitted.

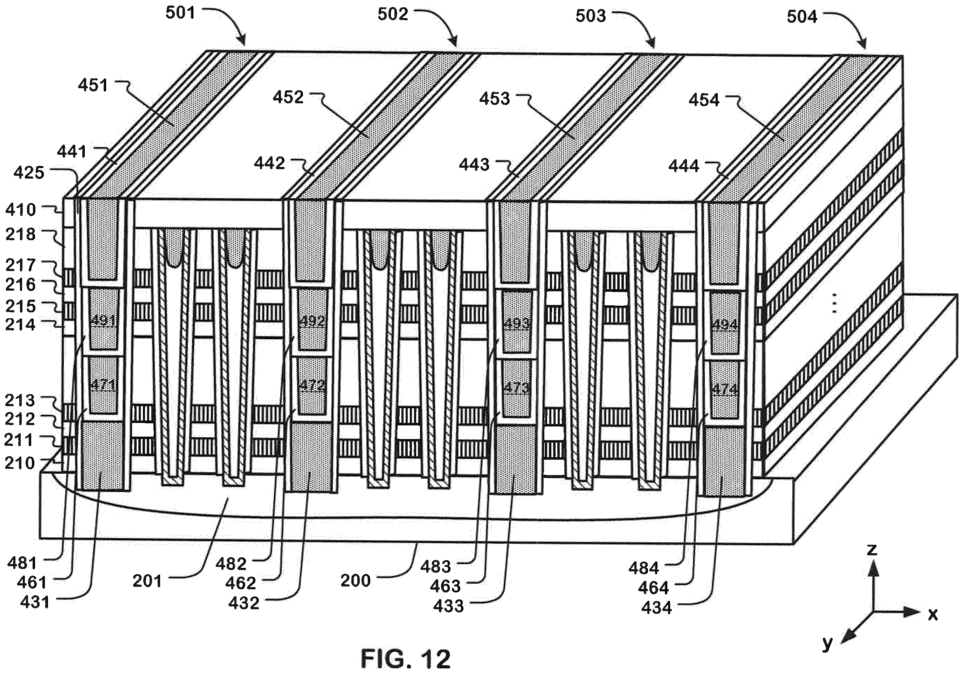

FIG. 12 is a perspective view of the three-dimensional memory structure in an alternative embodiment. The same reference numerals used in FIG. 11 are generally applied to FIG. 12 to refer to the same or like elements of an embodiment. Description about the same or like elements is not repeated. Compared with the structure of FIG. 11, the bottom conductor layer 431, 432, 433, 434 directly contacts the conductive layer 201. In this embodiment, the bottom conductor layer comprises for example polysilicon, which can provide good adhesion between the insulating and conducting materials. So the bottom conductive interface layers 421, 422, 423, 424 of FIG. 9 can be omitted.

In yet an alternative embodiment, the intermediate conductive interface layers (*e.g.* 461-464, 481-484) between the top and bottom conductor layers can be optionally omitted.

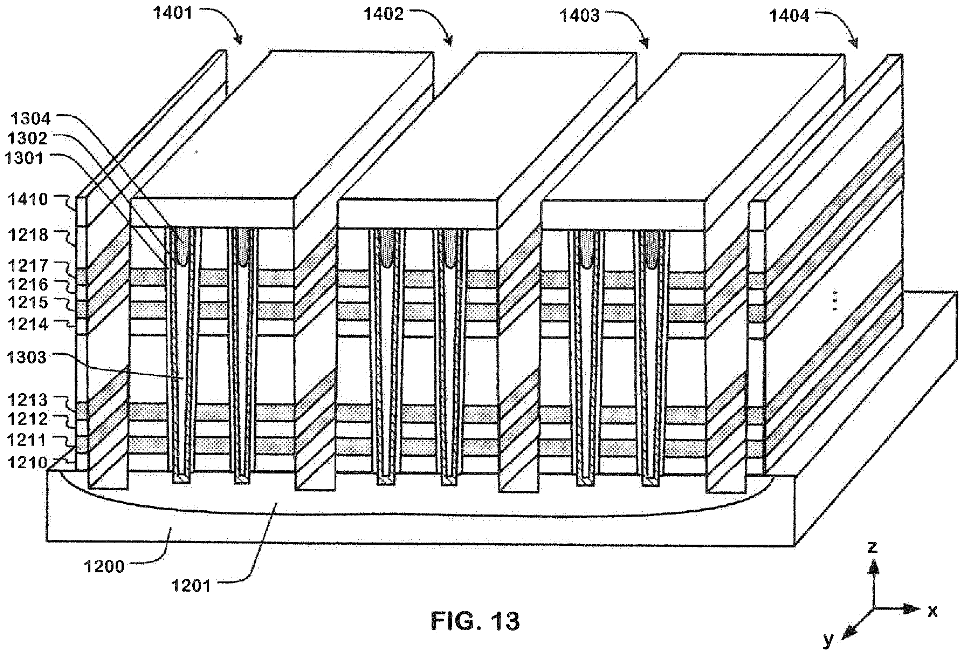

FIGs. 13 through 15 illustrate another example process flow for an integrated circuit comprising a vertical channel 3D memory device.

FIG. 13 is perspective view illustrating a structure having a plurality of elongated trenches (*e.g.* 1401, 1402, 1403, 1404) formed in a stack of alternating silicon oxide layers (*e.g.* 1210, 1212, 1214, 1216, 1218) and silicon nitride layers (*e.g.* 1211, 1213, 1215, 1217).

To form the structure as illustrated in FIG. 13, a substrate (or a conductive plate) 1200 can comprise a conductive layer 1202 formed by a doping process to add n-type or p-type doping materials to the substrate 1200, followed by deposition of a stack of alternating silicon oxide layers (*e.g.* 1210, 1212, 1214, 1216, 1218) and silicon nitride layers (*e.g.* 1211, 1213, 1215, 1217) on the substrate 1200.

Next, a hole etch is implemented to form a plurality of openings through the stack, followed by deposition of a memory layer 1301 on the stack and within the openings in the plurality. The memory layer 1301 is a composite, multilayer film comprising a first layer configured as a blocking layer comprising silicon oxide, a second layer configured as a charge trapping layer comprising silicon nitride, and a third layer configured as a tunneling comprising silicon oxide. The memory layer 1301 has a conformal surface on the sidewalls and bottoms of the openings in the plurality. Then, an etch process is carried out to remove the memory layer 1301 on the top of the stack and on the bottoms of the openings. A thin film 1302 is then deposited over the stack and has a portion in contact with the conductive layer 1201 at the bottoms of the openings. The thin film 1302 can comprise a semiconductor adapted by choice of material, *e.g.* silicon, and doping concentrations, *e.g.* undoped or lightly doped, to act as vertical channel structures.

After formation of the semiconductor thin film 1302, a fill-in process is implemented using a spin-on dielectric (SOD), for example silicon oxide or other insulating materials, to fill the space between the thin film 1302 within the openings, followed by a CMP process to remove the SOD on the top conductor layer 1218 and an etch process to remove the SOD in the upper portions of the openings. So the insulating structures 1303 are formed. In one example, the insulating structure 303 can be completely filled with the SOD, and be free of void and seam. In another example, a seam or a void may exist in the insulating structure 1303.

Next, a conductive material, for example polysilicon, is deposited to fill the upper portions of the openings, followed by CMP and/or etch back processes to form the plugs 1304, thereby providing connections from the channels in the vertical strings of memory cells to the corresponding overlying patterned conductors (not shown). A salicide process is optionally applied to lower the resistance for better conductivity. In another example, the plugs 1304 may comprise doped polysilicon.

In yet another example, the insulating structure 1303 can be a seam or a gap, which is formed during the deposition of the thin film 1302. The overhangs formed on the top of the inside surface of the thin film 1302 may connect together so as to form the seam or gap enclosed by the thin film 1302. The plug 1304 is therefore formed by the overhangs being connected.

In yet another example, the thin film 1302 completely fills the openings in the stack, and therefore, the insulating structure 1303 and the plug 1304 do not exist.

Next, a cap layer 1410 comprising for example silicon oxide is deposited on the stack, followed by a patterning process to form a plurality of elongated trenches (*e.g.* 1401, 1402, 1403, 1404) extending in the stack and into the conductive layer 201 of the substrate 200. The elongated trenches in the plurality can be greater than 1µm deep, up to 8 µm for example, and greater than 0.1 µm wide, up to 0.8 µm for example. As such, the elongated trenches in the plurality have an aspect ratio of 10 or more.

The elongated trenches in the plurality are formed using one single patterning step, in which includes defining an etch mask for trenches, and etching using the mask, without further etch masks, so as to have continuous sidewalls extending from an upper layer of the multilayer stack to the substrate 1200 beneath the multilayer stack.

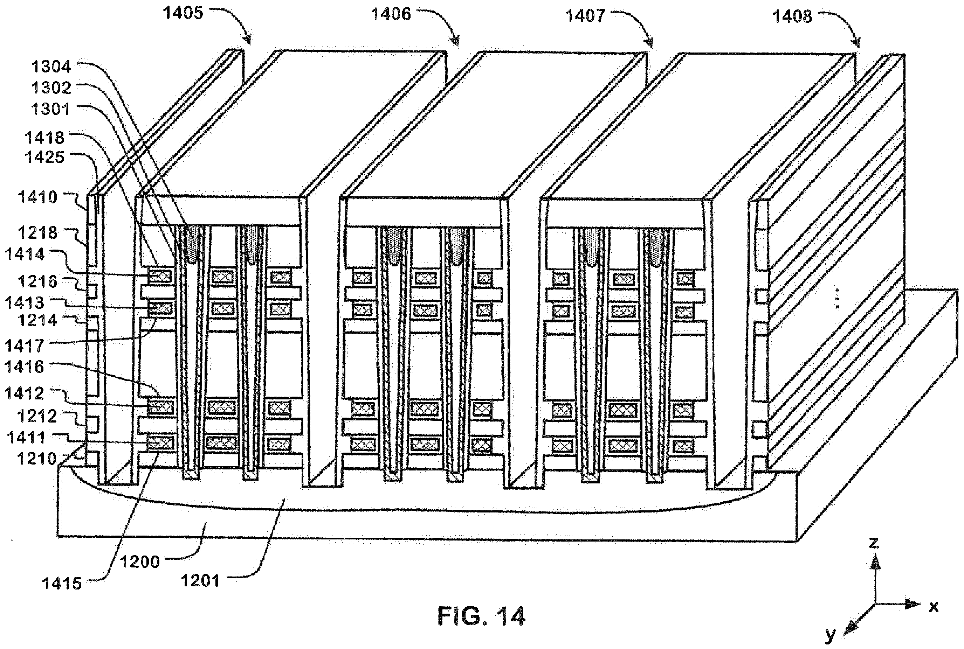

FIG. 14 is a perspective view illustrating a structure after formation of metal gates in place of the nitride layers in the stack and formation of an insulating layer 1425 on the sidewalls of the elongated trenches. A gate replacement process is implemented, which comprises (1) removing the silicon nitride layers (*e.g.* 1211, 1213, 1215, 1217 of FIG. 13) in the stack using phosphoric acid (H₃PO₄) to expose the surface of the silicon oxide layers and the surface of the memory layer, (2) forming a thin layer (*e.g.* 1415, 1416, 1417, 1418) of high-κ material like aluminum oxide on the exposed surface of the silicon oxide layers (*e.g.* 1210, 1212, 1214, 1216, 1218) in the stack and on the exposed surface of the memory layer 1301, and (3) forming the metal gates (*e.g.* 1411, 1412, 1413, 1414) using CVD or other suitable deposition methods by filling a conductive material like tungsten (W), tungsten nitride (WN), tantalum (Ta), tantalum nitride (TaN), titanium (Ti), titanium nitride (TiN), or the combinations thereof. A wet etch is then applied to remove the conductive material on the sidewalls and the bottoms of the elongated trenches, which creates recesses on the sidewalls.

After the gate replacement process, the stack comprises inactive layers consisting of the silicon oxide layers (*e.g.* 1210, 1212, 1214, 1216, 1218) and active layers consisting of the metal gates (*e.g.* 1411, 1412, 1413, 1414). The memory cells are disposed at the interface regions between the active layers and the pillars. In this embodiment, the active layers acting as the word lines surround the pillar, which constitutes the all-around gates. The memory cells have gate-all-around configuration.

Next, an oxidation process is implemented at a low temperature, for example 25°C to form an insulating layer 1425 comprising silicon oxide over the stack, followed by an oxide etch to remove the insulating layer 1425 on the bottoms of the elongated trenches. The resulting structure has the insulating layer 1425 covering the sides of the silicon oxide layers (*e*.*g*. 1210, 1212, 1214, 1216, 1218) in the stack and filling the recesses on the sidewalls. After the etch step, the insulating layer 1425 provides continuous sidewalls of the elongated trenches (*e.g.* 1405, 1406, 1407, 1408).

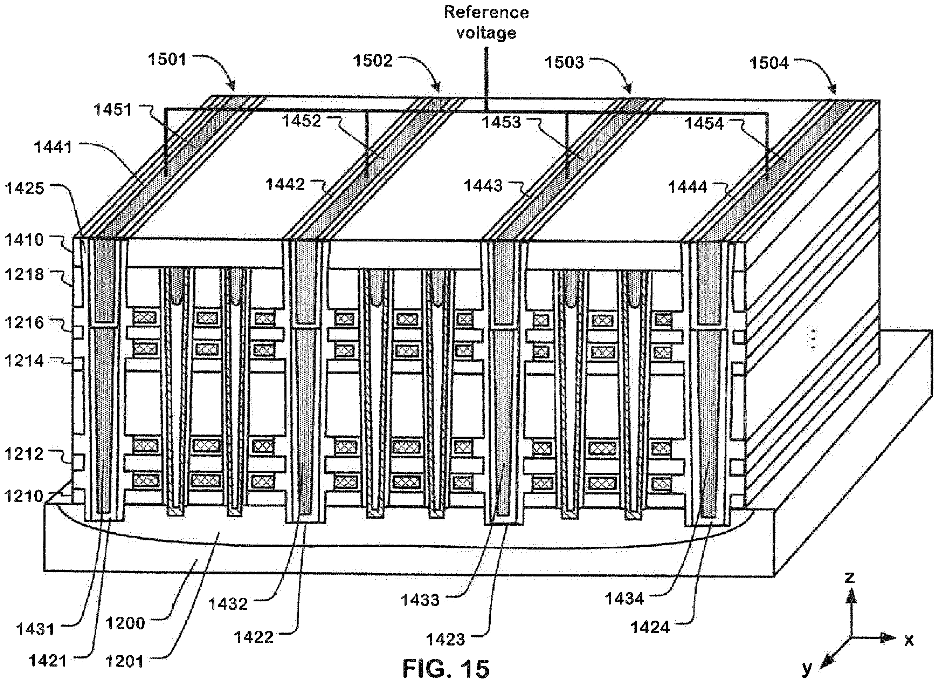

FIG. 15 is a perspective view illustrating a structure having a plurality of layered conductors (*e.g.* 1501, 1502, 1503, 1504) filling the elongated trenches. A first conductive thin layer is deposited over the stack using CVD, PVD, and ALD to form a layer of about 30Å to 1000 Å thick. An annealing process is then optionally applied to the deposited first conductive thin layer. A first conductor is followed to deposit using CVD, PVD, ALD, electroplating (EP) or other deposition techniques to partially fill in the space between the sidewalls of the first conductive thin layer within the elongated trenches. In this example, the first conductor fills the lower portion of the trenches in the plurality.

Next, a CMP process is first applied to remove the first conductive thin layer and the first conductor on the top of the cap layer 410, followed by an etch process to remove the first conductive thin layer and the first conductor on the upper sidewalls of the elongated trenches, thereby forming the bottom conductor layers (*e.g.* 1431, 1432, 1433, 1434) and the bottom conductive interface layers (*e.g.* 1421, 1422, 1423, 1424), and exposing a portion of insulating layer 1425 above the bottom conductor layers (*e.g.* 1431, 1432, 1433, 1434). The conductive materials for the bottom conductor layers (*e.g.* 1431, 1432, 1433, 1434) and the bottom conductive interface layers (*e.g.* 1421, 1422, 1423, 1424) are etched back to a top elevation in the stack forming a top surface for the bottom conductor layer. In this example, the top surface of the bottom conductor layer (*e.g.* 1431, 1432, 1433, 1434) can be at an elevation about two-thirds of the stack thickness, or can be at an elevation around the top active layer (*e.g.* 1414) of the stack. The etch process can comprise wet etching, dry etching, Ar bombard, or the combinations thereof. In another example, only etch process(es) is implemented.

The material suitable for the bottom conductor layer (*e.g.* 1431, 1432, 1433, 1434) of the layered conductor (*e.g.* 1501, 1502, 1503, 1504) may comprise silicon nitride (SiN), Titanium (Ti), titanium nitride (TiN), tungsten nitride (WN), tantalum (Ta), tantalum nitride (TaN), other metal alloys, or combinations thereof.

The material suitable for the bottom conductive interface layer (*e.g.* 1421, 1422, 1423, 1424) of the layered conductor (*e.g.* 1501, 1502, 1503, 1504) may comprise polysilicon, amorphous silicon, Titanium (Ti), titanium nitride (TiN), tungsten (W), tungsten nitride (WN), tantalum (Ta), tantalum nitride (TaN), aluminum (Al), copper (Cu), cobalt (Co), other metals and metal alloys, or combinations thereof. The bottom conductive interface layer can be a combination of multiple layers, such as Ti and TiN.

A second conductive thin layer is then deposited on the exposed portion of the insulating layer 1425 and on the top surface of the bottom conductor layer using CVD, PVD, ALD, or other deposition techniques to have a thickness about 10Å to 1000Å, lining a portion of the sidewalls of the elongated trenches, followed by depositing a second conductor to fill the upper portion of the elongated trenches using CVD, PVD, ALD, EP or other deposition techniques. Then, a CMP and/or etch process is applied to remove the second conductive thin layer and the second conductor on the top of the cap layer 1410. So the top conductor layers (*e.g.* 1451, 1452, 1453, 1454) and the intermediate conductive interface layers (*e.g.* 1441, 1442, 1443, 1444) are formed on the corresponding bottom conductor layers (*e.g.* 1431, 1432, 1433, 1434).

The material suitable for the intermediate conductive interface layers (*e.g.* 1441, 1442, 1443, 1444) may comprise silicon nitride (SiN), Titanium (Ti), titanium nitride (TiN), tungsten nitride (WN), tantalum (Ta), tantalum nitride (TaN), other metal alloys, or combinations thereof. The intermediate conductive interface layer can be a combination of multiple layers, such as Ti and TiN.

The material suitable for the top conductor layer (*e.g.* 1451, 1452, 1453, 1454) may comprise polysilicon, amorphous silicon, Titanium (Ti), titanium nitride (TiN), tungsten (W), tungsten nitride (WN), tantalum (Ta), tantalum nitride (TaN), aluminum (Al), copper (Cu), cobalt (Co), other metals and metal alloys, or combinations thereof.

The top conductor layer and bottom conductor layer can have the same or different materials. Likewise, the intermediate conductive interface layer and the bottom conductive interface layer can consist of the same or different materials.

Each of the layered conductors (*e.g.* 1501, 1502, 1503, 1504) in the plurality includes a bottom conductor layer (*e.g.* 1431, 1432, 1433, 1434) in ohmic electrical contact with the conductive layer 1201, an intermediate conductive interface layer (*e.g.* 1441,1442, 1443, 1444) over the bottom conductor layer (*e.g.* 1431, 1432, 1433, 1434) and lining a portion of the sidewall of the corresponding trench, and a top conductor layer (*e.g.* 1451, 1452, 1453, 1454) on the intermediate conductive interface layer (*e.g.* 1441, 1442, 1443, 1444). The ohmic contact provides for current flow communication with suitable resistance between the layered conductors filling the elongated trenches, and the underlying conductive layer 1201 to enable use of the conductive layer 1201 as a common source line. Each layered conductor also includes a bottom conductive interface layer (*e.g.* 1421, 1422, 1423, 1424) between the bottom conductor layer (*e.g.* 1431, 1432, 1433, 1434) and a lower portion of the sidewall adjacent the bottom conductor layer (*e.g.* 1431, 1432, 1433, 1434) in this embodiment.

As schematically shown, a plurality of patterned conductors overlying the plurality layered conductors (*e.g.* 1501, 1502, 1503, 1504) and the multilayer stack is connected the plurality of layered conductors to a reference voltage, configured as a common source line. In addition, a second plurality of patterned conductors (not shown) overlying the multilayer stack is connected the plurality of pillars to a voltage supply, providing bit line voltages to the corresponding thin films (1302 of FIG. 13) of the pillar, configured as bit lines. Control circuitry is configured to apply different bias voltages to the active layers and the pillars in the multilayer stack, and can be configured to execute a program operation by which one, or more than one, bit of data can be stored in a selected memory cell.

The bottom conductor layers 1431, 1432, 1433, 1434 can be bulk conductors, used primarily as a conductor as opposed to as a thin film adhesion layer or thin film barrier layer, of the layered conductors 1501, 1502, 1503 1504, having thicknesses sufficient to act as the primary bulk conductive material of the layered conductor in the trench. In effective embodiments, the bottom conductor layers 1431, 1432, 1433, 1434 have a thickness greater than a combined height of at least two of the layers (e.g. layers 1210, 1411) in the stack. In effective embodiments, the bottom conductor layers 1431, 1432, 1433, 1434 have a thickness of at least one-third of the stack height. In effective embodiments, the bottom conductor layers 1431, 1432, 1433, 1434 have a thickness of at least two-thirds of the stack height. The bottom conductor layers 1431, 1432, 1433, 1434 can be thicker in a dimension normal to the substrate 1200 than the top conductor layers 1451, 1452, 1453, 1454. The primary purpose of the bottom conductor layers 1431, 1432, 1433, 1434 is a bulk conductor.

The bottom conductive interface layers 1421, 1422, 1423, 1424 below the bottom conductor layers 1431, 1432, 1433, 1434 function primarily as adhesives to assist or ensure the adhesion of the bottom conductor layers to the insulating layer 425 or ion barriers to protect the underlying substrate 200 from attack by ions like fluorine and chlorine. The bottom conductive interface layers 1421, 1422, 1423, 1424 can also function to avoid forming voids or hillocks on the surface of the substrate during formation of the bottom conductor layers. In addition, the bottom conductive interface layers 1421, 1422, 1423, 1424 can help growth of the bottom conductor layers 1431, 1432, 1433, 1434.

The intermediate conductive interface layers 1441, 1442, 1443, 1444 function as primarily as adhesives to ensure the adhesion of the top conductor layers to the insulating layer 1425 and can help growth of the top conductor layers 1451, 1452, 1453, 1454.

In another embodiment, the bottom conductive interface layer can be omitted if the bottom conductor layer comprises for example polysilicon or other materials, which can provide good adhesion between the insulating and conducting materials. In this embodiment, the layered conductors, as described with reference to FIG. 10, includes the bottom conductor layers in direct contact with the conductive layer 1201. The bottom conductor layers 1431, 1432, 1433, 1434 are thicker than the top conductor layers 1451. 1452. 1453, 1454 in a dimension normal to the substrate 1200.

In yet another embodiment, the layered conductors, as described with reference to FIG. 11, can include an intermediate conductor layer and an intermediate conductive interface layer between the top and bottom conductor layers. The intermediate conductive interface layer can be optionally omitted.

In yet another embodiment, the layered conductors, as described with reference to FIG. 12, can include an intermediate conductor layer and an intermediate conductive interface layer between the top and bottom conductor layers, and the bottom conductor layers are in direct contact with the conductive layer. The intermediate conductive interface layers can be optionally omitted.

The layered conductors can be implemented in formation of other 3D memory structures.

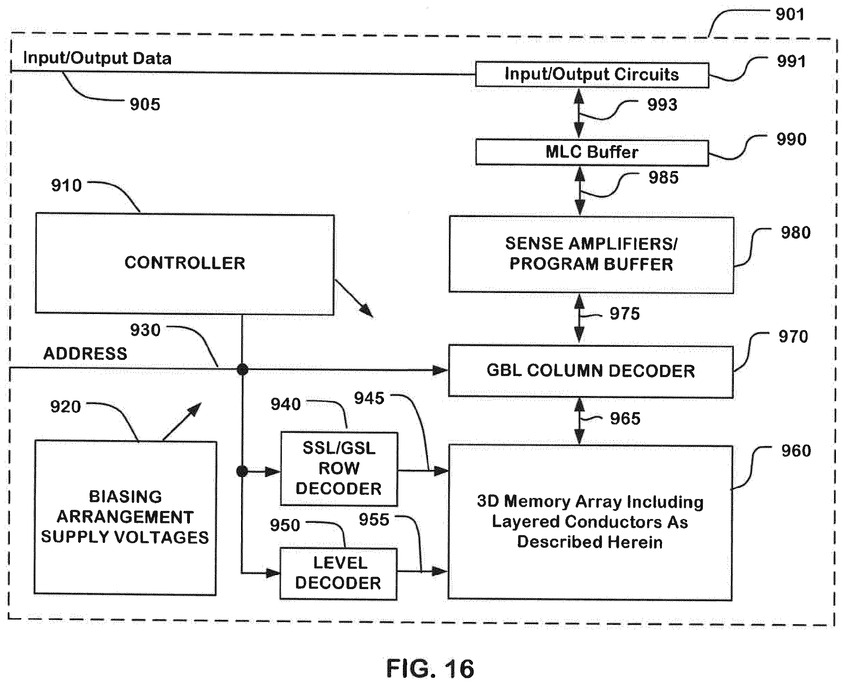

FIG. 16 is a simplified chip block diagram of an integrated circuit 901 including a 3D, vertical thin-channel film NAND array. The integrated circuit 901 includes a memory array 960 including one or more memory blocks having the layered conductors as described herein.

An SSL/GSL decoder 940 is coupled to a plurality of SSL/ GSL lines 945, arranged in the memory array 960. A level decoder 950 is coupled to a plurality of word lines 955. A global bit line column decoder 970 is coupled to a plurality of global bit lines 965, arranged along columns in the memory array 960 for reading data from and writing data to the memory array 960. Addresses are supplied on bus 930 from control logic 910 to decoder 970, decoder 940 and decoder 950. Sense amplifier and program buffer circuits 980 are coupled to the column decoder 970, in this example via first data lines 975. The program buffer in circuits 980 can store program codes for multiple-level programming, or values that are a function of the program codes, to indicate program or inhibit states for selected bit lines. The column decoder 970 can include circuits for selectively applying program and inhibit voltages to bit lines in the memory in response to the data values in the program buffer.

Sensed data from the sense amplifier/program buffer circuits 980 are supplied via second data lines 985 to multi-level data buffer 990, which is in turn coupled to input/output circuits 991 via a data path 993. Also, input data is applied in this example to the multi-level data buffer 990 for use in support of multiple-level program operations for each of the independent sides of the independent double gate cells in the array.

Input/output circuits 991 drive the data to destinations external to the integrated circuit 901. Input/output data and control signals are moved via data bus 905 between the input/output circuits 991, the control logic 910 and input/output ports on the integrated circuit 901 or other data sources internal or external to the integrated circuit 901, such as a general purpose processor or special purpose application circuitry, or a combination of modules providing system-on-a-chip functionality supported by the memory array 960.

In the example shown in FIG. 16, control logic 910, using a bias arrangement state machine, controls the application of supply voltages generated or provided through the voltage supply or supplies in block 920, such as read, erase, verify and program bias voltages. The control logic 910 is coupled to the multi-level data buffer 990 and the memory array 960. The control logic 910 includes logic to control multiple-level program operations. In embodiments supporting the Gate-All-Around (GAA) NAND structures described herein, the logic is configured to perform the method of:
applying a reference voltage to common source lines, such as biasing the conductive layer on the substrate via the layered conductors described herein;
selecting a layer of memory cells in the array, such as using a word line layer decoder;
selecting vertical channel structures in a selected row in the array such as by using SSL switches and GSL switches on the rows of vertical channel structures; and
storing charge in charge trapping sites in the selected layer on the selected row of vertical channel structures in the array, to represent data using bit line circuitry like page buffers on global bit lines coupled to the selected row of vertical channel structures.

In some embodiments, the logic is configured to select a layer, such as by controlling word line layer decoders.

In some embodiments, the logic is configured to store multiple levels of charge to represent more than one bit of data in the charge trapping sites in the selected layer on the selected row of vertical channel structures in the array. In this manner, a selected cell in the array stores more than two bits, including more than one bit on each cell.

The control logic 910 can be implemented using special-purpose logic circuitry as known in the art. In alternative embodiments, the control logic comprises a general-purpose processor, which can be implemented on the same integrated circuit, which executes a computer program to control the operations of the device. In yet other embodiments, a combination of special-purpose logic circuitry and a general-purpose processor can be utilized for implementation of the control logic.

The memory array 960 can comprise charge trapping memory cells configured to store multiple bits per cell, by the establishment of multiple program levels that correspond to amounts of charge stored, which in turn establish memory cell threshold voltages V_{T}. As mentioned above, single-bit-per-cell embodiments can include the structures described herein.

While the present invention is disclosed by reference to the preferred embodiments and examples detailed above, it is to be understood that these examples are intended in an illustrative rather than in a limiting sense. It is contemplated that modifications and combinations will readily occur to those skilled in the art, which modifications and combinations will be within the scope of the following claims.

## Claims

1. An integrated circuit comprising:
a multilayer stack of active and inactive layers (210 to 218) over a substrate (200);
a plurality of elongated trenches (401, 402, 403, 404) in the multilayer stack, the elongated trenches (401, 402, 403, 404) in the plurality extending from an upper layer of the multilayer stack to the substrate (200) beneath the multilayer stack, and having sidewalls; and
a plurality of layered conductors (501, 502, 503, 504) filling the corresponding elongated trenches (401, 402, 403, 404) in the plurality of elongated trenches (401, 402, 403, 404), each layered conductor (501, 502, 503, 504) in the plurality of layered conductors (501, 502, 503, 504) including a bottom conductor layer (431, 432, 433, 434) in electrical contact with the substrate (200), a top conductor layer (218) over the bottom conductor layer (431, 432, 433, 434), and an intermediate interface layer between the top conductor layer (218) and the bottom conductor layer (431, 432, 433, 434) and on a portion of the sidewalls of the corresponding elongated trench (401, 402, 403, 404).

2. The integrated circuit of claim 1, wherein the layered conductor (501, 502, 503, 504) further includes a bottom conductive interface layer (421, 422, 423, 424) between the bottom conductor layer (431, 432, 433, 434) and the substrate (200) and on a lower portion of the sidewall adjacent the bottom conductor layer (431, 432, 433, 434).

3. The integrated circuit of any one of the preceding claims, further comprising an insulating layer (425) between the layered conductor (501, 502, 503, 504) and the multilayer stack.

4. The integrated circuit of any one of the preceding claims, wherein the elongated trenches (401, 402, 403, 404) in the plurality of elongated trenches (401, 402, 403, 404) have aspect ratios of 10 or more, and depths of at least one micron with continuous sidewalls.

5. The integrated circuit of any one of the preceding claims, wherein the intermediate interface layer comprises an adhesive for the insulating layer (425) and the top conductor layer (218).

6. The integrated circuit of any one of the preceding claims, wherein the layered conductor (501, 502, 503, 504) further includes an intermediate conductive layer between the top and bottom conductor layers and the intermediate interface layer is in contact with a top surface of the intermediate conductive layer.

7. The integrated circuit of any one of the preceding claims, wherein the bottom conductor layer (431, 432, 433, 434) is configured to act primarily as a bulk conductor, and is thicker in a dimension orthogonal to the substrate (200) than a combined height of at least two of the layers in the multilayer stack.

8. The integrated circuit of any one of the preceding claims, wherein the multilayer stack comprises a 3D memory structure; and the substrate (200) includes a conductive layer (201) in current flow communication with the plurality of layered conductors (501, 502, 503, 504) configured as a common source line, and one or more patterned conductor layers overlying the stack including connections to the plurality of layered conductors (501, 502, 503, 504).

9. The integrated circuit of any one of the preceding claims, wherein the top and bottom conductor layers comprise different conductive materials.

10. A method of manufacturing an integrated circuit comprising:
forming a multilayer stack of active and inactive layers (210 to 218) over a substrate (200);
forming a plurality of elongated trenches (401, 402, 403, 404) in the multilayer stack, the elongated trenches (401, 402, 403, 404) in the plurality of elongated trenches (401, 402, 403, 404) extending from an upper layer of the multilayer stack to the substrate (200) beneath the multilayer stack;
lining sides of the elongated trenches (401, 402, 403, 404) in the plurality of elongated trenches (401, 402, 403, 404) with an insulating layer (425); and
filling the elongated trenches (401, 402, 403, 404) in the plurality of elongated trenches (401, 402, 403, 404) with layered conductors (501, 502, 503, 504), including forming the layered conductors (501, 502, 503, 504) in the corresponding elongated trenches (401, 402, 403, 404) in the plurality of elongated trenches (401, 402, 403, 404) by forming a bottom conductor layer (431, 432, 433, 434) in the corresponding elongated trench (401, 402, 403, 404) over the insulating layer (425) and in electrical contact with the substrate (200), forming an intermediate conductive interface layer over the bottom conductor layer (431, 432, 433, 434) and lining a portion of the insulating layer (425), and forming a top conductor layer (218) on the intermediate conductive interface layer.

11. The method of claim 10, wherein said forming the bottom conductor layer (431, 432, 433, 434) includes partially filling the corresponding elongated trench (401, 402, 403, 404) with a conductive material, and etching the conductive material back to a top elevation in the stack forming a top surface of the bottom conductor layer (431, 432, 433, 434) and to expose a portion of the insulating layer (425) above the bottom conductor layer (431, 432, 433, 434).

12. The method of claim 10 or 11, wherein said forming the intermediate conductive interface layer includes forming the intermediate conductive interface layer on the exposed portion of the insulating layer (425) and on the top surface of the bottom conductor layer; and/or
said forming the plurality of elongated trenches (401, 402, 403, 404) includes defining an etch pattern for the elongated trenches (401, 402, 403, 404), and etching using the etch pattern trenches to a depth greater than 1 micron, with an aspect ratio of 10 or more, such that said forming of the plurality of elongated trenches (401, 402, 403, 404) is done without further etch patterns.

13. The method of any one of claims 10 to 12, wherein said forming the plurality of layered conductors (501, 502, 503, 504) includes etching back material of the bottom conductor layer before forming the intermediate interface layer, and using the insulating layer (425) for alignment of the etching back; and/or said forming the top and bottom conductor layers includes depositing different conductive materials

14. The method of any one of claims 10 to 13, further comprising forming a bottom conductive interface layer between the bottom conductor layer (431, 432, 433, 434) and the substrate (200) and on a lower portion of the insulating layer (425) adjacent the bottom conductor layer (431, 432, 433, 434).

15. The method of any one of claims 10 to 14, wherein the bottom conductor layer (431, 432, 433, 434) acts primarily as a bulk conductor, and is thicker in a dimension orthogonal to the substrate (200) than a combined height of at least two of the layers in the multilayer stack.

## Amended claims

### Amended claims in accordance with Rule 137(2) EPC.

1. An integrated circuit comprising:
a multilayer stack of active and inactive layers (210 to 218) over a substrate (200);
a plurality of elongated trenches (401, 402, 403, 404) in the multilayer stack, the elongated trenches (401, 402, 403, 404) in the plurality extending from an upper layer of the multilayer stack to the substrate (200) beneath the multilayer stack, and having sidewalls; and
a plurality of layered conductors (501, 502, 503, 504) filling the corresponding elongated trenches (401, 402, 403, 404) in the plurality of elongated trenches (401, 402, 403, 404), each layered conductor (501, 502, 503, 504) in the plurality of layered conductors (501, 502, 503, 504) including a bottom conductor layer (431, 432, 433, 434) in electrical contact with the substrate (200), a top conductor layer (218) over the bottom conductor layer (431, 432, 433, 434), and an intermediate interface layer between the top conductor layer (218) and the bottom conductor layer (431, 432, 433, 434) and on a portion of the sidewalls of the corresponding elongated trench (401, 402, 403, 404); and
an insulating layer (425) between the layered conductor (501, 502, 503, 504) and the multilayer stack,
wherein the intermediate interface layer is formed lining the insulating layer (425) on the portion of the sidewalls of the corresponding elongated trench (401, 402, 403, 404).

2. The integrated circuit of claim 1, wherein the layered conductor (501, 502, 503, 504) further includes a bottom conductive interface layer (421, 422, 423, 424) between the bottom conductor layer (431, 432, 433, 434) and the substrate (200) and on a lower portion of the sidewall adjacent the bottom conductor layer (431, 432, 433, 434).

3. The integrated circuit of any one of the preceding claims, wherein the elongated trenches (401, 402, 403, 404) in the plurality of elongated trenches (401, 402, 403, 404) have aspect ratios of 10 or more, and depths of at least one micron with continuous sidewalls.

4. The integrated circuit of any one of the preceding claims, wherein the intermediate interface layer comprises an adhesive for the insulating layer (425) and the top conductor layer (218).

5. The integrated circuit of any one of the preceding claims, wherein the layered conductor (501, 502, 503, 504) further includes an intermediate conductive layer between the top and bottom conductor layers and the intermediate interface layer is in contact with a top surface of the intermediate conductive layer.

6. The integrated circuit of any one of the preceding claims, wherein the bottom conductor layer (431, 432, 433, 434) is configured to act primarily as a bulk conductor, and is thicker in a dimension orthogonal to the substrate (200) than a combined height of at least two of the layers in the multilayer stack.

7. The integrated circuit of any one of the preceding claims, wherein the multilayer stack comprises a 3D memory structure; and the substrate (200) includes a conductive layer (201) in current flow communication with the plurality of layered conductors (501, 502, 503, 504) configured as a common source line, and one or more patterned conductor layers overlying the stack including connections to the plurality of layered conductors (501, 502, 503, 504).

8. The integrated circuit of any one of the preceding claims, wherein the top and bottom conductor layers comprise different conductive materials.

9. A method of manufacturing an integrated circuit comprising:
forming a multilayer stack of active and inactive layers (210 to 218) over a substrate (200);
forming a plurality of elongated trenches (401, 402, 403, 404) in the multilayer stack, the elongated trenches (401, 402, 403, 404) in the plurality of elongated trenches (401, 402, 403, 404) extending from an upper layer of the multilayer stack to the substrate (200) beneath the multilayer stack;
lining sides of the elongated trenches (401, 402, 403, 404) in the plurality of elongated trenches (401, 402, 403, 404) with an insulating layer (425); and
filling the elongated trenches (401, 402, 403, 404) in the plurality of elongated trenches (401, 402, 403, 404) with layered conductors (501, 502, 503, 504), including forming the layered conductors (501, 502, 503, 504) in the corresponding elongated trenches (401, 402, 403, 404) in the plurality of elongated trenches (401, 402, 403, 404) by:
forming a bottom conductor layer (431, 432, 433, 434) in the corresponding elongated trench (401, 402, 403, 404) over the insulating layer (425) and in electrical contact with the substrate (200), wherein said forming the bottom conductor layer (431, 432, 433, 434) includes filling the corresponding elongated trench (401, 402, 403, 404) with a conductive material, and etching the conductive material back to a top elevation in the stack forming a top surface of the bottom conductor layer (431, 432, 433, 434) and to expose a portion of the insulating layer (425) above the bottom conductor layer (431, 432, 433, 434),
forming an intermediate conductive interface layer over the bottom conductor layer (431, 432, 433, 434) and lining the exposed portion of the insulating layer (425), and
forming a top conductor layer (218) on the intermediate conductive interface layer.

10. The method of claim 9, wherein in said filling the corresponding elongated trench (401, 402, 403, 404) with a conductive material, the corresponding elongated trench (401, 402, 403, 404) is partially filled by the conductive material.

11. The method of claim 9 or 10, wherein said forming the intermediate conductive interface layer includes forming the intermediate conductive interface layer on the exposed portion of the insulating layer (425) and on the top surface of the bottom conductor layer; and/or
said forming the plurality of elongated trenches (401, 402, 403, 404) includes defining an etch pattern for the elongated trenches (401, 402, 403, 404), and etching using the etch pattern trenches to a depth greater than 1 micron, with an aspect ratio of 10 or more, such that said forming of the plurality of elongated trenches (401, 402, 403, 404) is done without further etch patterns.

12. The method of any one of claims 9 to 11, wherein said forming the plurality of layered conductors (501, 502, 503, 504) includes etching back material of the bottom conductor layer before forming the intermediate interface layer, and using the insulating layer (425) for alignment of the etching back; and/or said forming the top and bottom conductor layers includes depositing different conductive materials.

13. The method of any one of claims 9 to 12, further comprising forming a bottom conductive interface layer between the bottom conductor layer (431, 432, 433, 434) and the substrate (200) and on a lower portion of the insulating layer (425) adjacent the bottom conductor layer (431, 432, 433, 434).

14. The method of any one of claims 9 to 13, wherein the bottom conductor layer (431, 432, 433, 434) acts primarily as a bulk conductor, and is thicker in a dimension orthogonal to the substrate (200) than a combined height of at least two of the layers in the multilayer stack.
